# EUROPEAN PATENT SPECIFICATION

(11) **EP 2 294 241 B1**
(45) Date of publication and mention of the grant of the patent: **22.02.2012**
(21) Application number: 09793942.5
(22) Date of filing: 07.07.2009
(51) Int. Cl.: C23C 14/34, C23C 14/08

(54) **A METHOD TO MANUFACTURE AN OXIDE SPUTTER TARGET COMPRISING A FIRST AND SECOND PHASE**
VERFAHREN ZUR HERSTELLUNG EINES OXID-SPUTTERTARGETS MIT EINER ERSTEN UND EINER ZWEITEN PHASE
PROCÉDÉ DE FABRICATION D'UNE CIBLE DE PULVÉRISATION CATHODIQUE À BASE D'OXYDE COMPRENANT UNE PREMIÈRE ET UNE SECONDE PHASE

(30) Priority: 08.07.2008 EP 08159926
(43) Date of publication of application: 16.03.2011
(73) Proprietor: Bekaert Advanced Coatings, 9800 Deinze (BE)
(72) Inventor: DELRUE, Hilde, B-7750 Mont-de-L'Enclus (BE); VAN HOLSBEKE, Johnny, B-7890 Ellezelles (BE); CARVALHO, Nuno, Jorge, Marcolino, B-9051 Sint-Denijs-Westrem (BE); DE BOSSCHER, Wilmert, B-9031 Drongen (BE)
(74) Representative: Messely, Marc
(86) International application number: PCT/EP2009/058593
(87) International publication number: WO 2010/003947

(56) References cited:
- US-A- 5 480 532
- US-A1- 2007 131 536

## Description

### Technical Field

The invention relates to a method to manufacture an oxide sputter target comprising a first phase comprising an oxide of a first and a second metal and a second phase comprising a metal.
The invention further relates to an oxide sputter target comprising a first phase comprising an oxide of a first and a second metal and a second phase comprising a metal.

### Background Art

Over the last decades magnetron sputtering has become a well-known technique to deposit thin coatings such as metal coatings or ceramic coatings.

The technique of sputtering is typically used to deposit optical coatings. An important group of optical coatings are the transparent conductive oxides such as indium tin oxide (ITO) as they combine electrical conductivity and optical transparency. Applications range from flat panel displays, smart windows, touch panels, electro-luminescent lamps to EMI shielding applications.

ITO coatings can be obtained by reactive sputtering of metallic indium tin alloy targets or by non reactive or pseudo reactive sputtering from ceramic oxide targets.

A drawback of the reactive sputtering of metallic indium tin alloy targets is that an accurate reactive gas control system is required to be able to deposit the desired stoichiometry uniformly over the substrate and to guarantee that the process is stable over time (hysteresis effect).
US 2007/0141536 describes a metal target to be used in a reactive sputter process. The hysteresis effect is limited by adding an amount of oxide to the metal target.

Sputtering from an oxide target on the other hand has the drawback that nodules are formed in an eroded part of the surface of the sputter target. These nodules are considered to be low level oxides of indium and/or tin.

During sputtering the number and size of the nodules increase and they gradually spread over the target surfaces. As the conductivity of the nodules is lower abnormal discharge (arcing) may occur leading to an unstable sputter process and defects in the deposited coating.

US 5,480,532 describes an oxidic target manufactured by hot isostatic pressing of indium oxide-tin oxide.

### Disclosure of Invention

It is an object of the present invention to provide a method to manufacture an oxide sputter targets avoiding the problems of the prior art.

It is another object of the present invention to provide a sputter target comprising an oxidic phase and a metallic phase.

It is a further object of the invention to provide a sputter target having an increased electrical and thermal conductivity so that the sputter target can be used at high power levels.

According to a first aspect of the present invention a method to manufacture an oxide sputter target is provided. The method comprises the steps of
- providing a target holder;
- applying an outer layer of a sputterable material on said target holder by simultaneously spraying at least one oxide and at least one metal, said outer layer comprising a first phase and a second phase, said first phase comprising an oxide of at least a first metal and a second metal; said second phase comprising a metal in its metallic phase; whereby said metal in its metallic phase forms discrete volumes arranged in or between said oxide of said first phase.

In a preferred embodiment the second phase consists of metal in its metallic phase.

The outer layer comprises between 0.1 and 20 wt% metal in its metallic phase. More preferably, the outer layer comprises between 1 and 15 wt% metal in its metallic phase or the outer layer comprises between 1 and 10 wt% metal in its metallic phase.
Most preferably, the outer layer comprises between 0.1 and 5 wt% metal in its metallic phase, for example between 2 and 5 wt% or between 3 and 5wt%, the remainder of the outer layer being said oxide.

In a preferred embodiment the metal of the metallic phase consists of the first metal of the oxide of the first phase. In an alternative embodiment the metal of the metallic phase consists of the second metal of the oxide of the first phase.

The first phase of the outer layer is an oxidic phase, whereas the second phase is a metallic phase.
For the purpose of this invention with "oxidic phase" is meant any phase comprising an oxide.
With "metallic phase" is meant any phase made of or containing a metal.

As mentioned above, the metal in its metallic phase forms discrete volumes arranged in or between volumes of the oxide in its oxidic phase. Preferably, the metal in its metallic phase is fully surrounded by volumes of oxide.
This means that two separated phases are present in the outer layer although grain boundaries and/or interdiffusion layers between the two phases can be present. Grain boundaries are interfaces where the two phases meet. Interdiffusion layers are layers where the two phase interdiffuse. However, the interdiffusion layer according to the present invention has a thickness that is limited to a few atomic layers.

As oxide any oxide of a first metal A and a second metal B can be considered. For the purpose of this invention with an oxide of a first metal A and a second metal B is meant any mixture of an oxide of the first metal with an oxide of the second metal (AₓO_{y} and BₓO_{y}) and any complex oxide of the general fomula AₓByO_{z} either stoichiometeric or non-stoichiometric.

For example with indium tin oxide is meant any mixture of indium oxide (InₓOy) and tin oxide (SnₓO_{y}) as for example ln₂O₃ and SnO₂ as well as complex oxides of the formula InₓSn_{y}O_{z} either stoichimetric or non-stoichiometric.

In principle any metal can be considered as first metal or as second metal of the oxide of the first phase, i.e. the oxidic phase. Preferably, the first metal and the second metal are selected from the group consisting of the elements of group Ila of the periodic system, the elements of group IIb of the periodic system, the elements of group llla of the periodic system, the elements of group IVa of the periodic system, titanium, niobium, tantalum, molybdenum and antimony. Most preferably, the first and/or the second metal comprise magnesium, calcium, titanium, niobium, tantalum, molybdenum, zinc, cadmium, boron, aluminium, gallium, indium, germanium, tin or antimony.

The first metal is preferably selected from the group consisting of magnesium, calcium, titanium, zinc, cadmium, gallium, indium and tin.

The second metal is preferably selected from the group consisting of magnesium, calcium, titanium, niobium, tantalum, molybdenum, zinc, cadmium, boron, aluminium, gallium, indium, germanium, tin and antimony.

Preferred oxides of a first and a second metal comprises indium tin oxides such as ln₄Sn₃O₁₂, indium zinc oxides, cadmium tin oxides, zinc tin oxides such as ZnSnO₃ and Zn₂SnO₄, zinc indium oxides such as Zn₂ln₂O₅ and Zn₃ln₂O₆, zinc aluminium oxides, magnesium indium oxides Mgln₂O₄ gallium indium oxide such as GalnO₃ and (Galn)₂O₃.

The metal of the metallic phase is preferably selected from the group consisting of the elements of group Ila of the periodic system, the elements of group Ilb of the periodic system, the elements of group Illa of the periodic system, the elements of group IVa of the periodic system and titanium, niobium, tantalum, molybdenum and antimony.
Preferred elements of group Ila, group Ilb, group llla and group IV of the periodic system are magnesium, calcium, zinc, cadmium, boron, aluminium, gallium, indium, germanium and tin.
A further preferred metal of the metallic phase is niobium.

Preferred combinations of the first phase (oxidic phase) and the second phase (metallic phase) are :
- indium tin oxide as oxidic phase and indium as metallic phase;
- indium tin oxide as oxidic phase and tin as metallic phase;
- indium tin oxide as oxidic phase and zinc as metallic phase.

The target holder of the sputter target according to the present invention may have any shape. Preferred target holders are planar target holders or tubular target holders.

It can be preferred to apply a bond layer on the target holder before the application of the outer layer of a sputterable material is applied. As bond layer any bond layer known in the art can be considered. Preferred bond layers comprise a metal or a metal alloy.

According to a second aspect of the present invention a sputter target is provided. The sputter target comprises a target holder and an outer layer of a sputterable material applied on the target holder. The outer layer comprises at least a first phase and a second phase. The first phase comprises an oxide of at least a first metal and a second metal; the second phase comprises a metal in its metallic phase. The metal in its metallic phase is thereby forming discrete volumes arranged in or between the oxide of said first phase.

The outer layer comprises between 0.1 and 20 wt% metal in its metallic phase. More preferably, the outer layer comprises between 1 and 15 wt% metal in its metallic phase or the outer layer comprises between 1 and 10 wt% metal in its metallic phase.
Most preferably, the outer layer comprises between 0.1 and 5 wt% metal in its metallic phase, for example between 2 and 5 wt% or between 3 and 5wt%, the remainder of the outer layer being said oxide.

In a preferred embodiment the metal of the metallic phase consists of the first metal of the oxide of the oxidic phase or of the second metal of the oxide of the oxidic phase.

The target holder of the sputter target according to the present invention may have any shape. Preferred target holders are planar target holders or tubular target holders.

An advantage of a sputter target according to the present invention is that during sputtering of such a target nodule formation is avoided. Furthermore, the sputter targets according to the present invention have an increased electrical and thermal conductivity so that these sputter targets can be used at high power levels.

### Brief Description of Figures in the Drawings

The invention will now be described into more detail with reference to the accompanying drawings wherein
- Figure 1 is a cross-section of a first embodiment of a sputter target according to the present invention;
- Figure 2 is a cross-section of a second embodiment of a sputter target according to the present invention.

### Mode(s) for Carrying Out the Invention

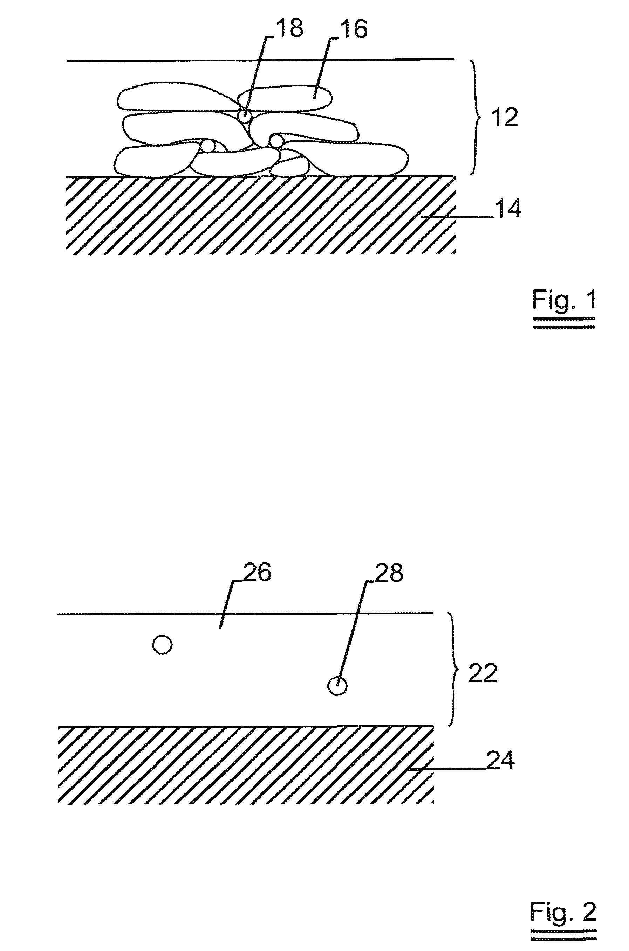

Referring to Figure 1 a cross-section of a sputter target according to the present invention is described. The outer layer 12 is applied on a target holder 14. The outer layer comprises a first phase 16 and a second phase 18. The first phase 16 is an oxidic phase. The second phase 18 is a metallic phase.

The first phase 16 comprises an oxide of at least a first metal and a second metal as for example indium tin oxide. In a preferred embodiment the oxidic phase comprises oxide volumes having a splat-like structure.

The second phase 18 comprises a metal. The metal of the second phase 18 is preferably the first metal of the oxide of the first phase 16 or the second metal of the oxide of the first phase 16. Alternatively, the metal of the second phase 18 comprises a metal other than the first metal or the second metal of the first phase.

In a preferred embodiment the outer layer of sputterable material comprises indium tin oxide as first phase (oxidic phase) and tin as second phase (metallic phase).

The metal of the second phase 18 forms discrete volumes arranged between volumes of the oxide of the first phase 16.

Figure 2 shows a cross-section of an alternative embodiment of a sputter target according to the present invention. An outer layer 22 is applied on a target holder 24. The outer layer comprises a first phase 26 and a second phase 28. The first phase 26 is an oxidic phase. The second phase 28 is a metallic phase.

The metal in its metallic phase 28 forms discrete volumes arranged in the oxide of the oxidic phase 26.

## Claims

1. A method to manufacture a oxide sputter target, said method comprising the steps of
- providing a target holder;
- applying an outer layer of a sputterable material on said target holder by simultaneously spraying at least one oxide and at least one metal, said outer layer comprising a first phase and a second phase, said first phase comprising an oxide of at least a first metal and a second metal, said second phase comprising a metal in its metallic phase, whereby said metal in its metallic phase forms discrete volumes arranged in or between said oxide of said first phase, said outer layer comprising between 0.1 and 20 wt% metal in its metallic phase.

2. A method according to claim 1, whereby said outer layer comprises between 0.1 and 5 wt% metal in its metallic phase, the remainder of said outer layer being oxide.

3. A method according to claim 1 or 2, whereby said metal of said second phase consists of said first metal of said oxide or of said second metal of said oxide.

4. A method according to any one of the preceding claims, whereby said first metal of said oxide and/or said second metal of said oxide is/are selected from the group consisting of the elements of group Ila of the periodic system, the elements of group llb of the periodic system, the elements of group Illa of the periodic system, the elements of group IVa of the periodic system, titanium, niobium, tantalum, molybdenum and antimony.

5. A method according to any one of the preceding claims, whereby said first metal of said oxide is selected from the group consisting of magnesium, calcium, titanium, zinc, cadmium, gallium, indium and tin.

6. A method according to any one of the preceding claims, whereby said second metal of said oxide is selected from the group consisting of magnesium, calcium, titanium, niobium, tantalum, molybdenum, zinc, cadmium, boron, aluminium, gallium, indium, germanium, tin and antimony.

7. A method according to any one of the preceding claims, whereby said oxide is selected from the group consisting of indium tin oxides, indium zinc oxides, cadmium tin oxides, zinc tin oxides, zinc indium oxides, zinc aluminium oxides, magnesium indium oxides and gallium indium oxides.

8. A method according to any one of the preceding claims, whereby said metal of said metallic phase is selected from the group consisting of the elements of group IIa of the periodic system, the elements of group llb of the periodic system, the elements of group IIIa of the periodic system, the elements of group lVa of the periodic system, titanium, niobium, tantalum, molybdenum and antimony.

9. A method according to any one of the preceding claims, whereby said target holder comprises a planar or a tubular target holder.

10. A method according to any one of the preceding claims, whereby said method further comprises the step of applying a bond layer on said target holder before the application of said outer layer of a sputterable material.

11. An oxide sputter target comprising a target holder and an outer layer of a sputterable material, said outer layer of a sputterable material obtainable by simultaneously spraying at least one oxide and at least one metal, said outer layer comprising a first phase and a second phase, said first phase comprising an oxide of at least a first metal and a second metal, said second phase comprising a metal in its metallic phase, whereby said metal in its metallic phase forms discrete volumes arranged in or between said oxide of said first phase, said outer layer comprising between 0.1 and 20 wt% metal in its metallic phase.

12. An oxide sputter target according to claim 11, whereby said outer layer comprises between 0.1 and 5 wt% metal in its metallic phase, the remainder of said outer layer being oxide.

13. An oxide sputter target according to claim 11 or 12, whereby said metal of said second phase consists of said first metal of said oxide or of said second metal of said oxide.

14. An oxide sputter target according to any one of claims 11 to 13 method according to any one of the preceding claims, whereby said first metal of said oxide and/or said second metal of said oxide is/are selected from the group consisting of the elements of group Ila of the periodic system, the elements of group llb of the periodic system, the elements of group Illa of the periodic system, the elements of group IVa of the periodic system, titanium, niobium, tantalum, molybdenum and antimony.

15. An oxide sputter target according to any one of claims 11 to 14, whereby said target holder comprises a planar or a tubular target holder.

## Patentansprüche

1. Verfahren zur Herstellung eines Oxid-Sputtertargets, wobei das Verfahren die Folgenden Schritte umfasst:
- Bereitstellen einer Trägerplatte;
- Aufbringen einer äußeren Schicht aus einem zerstäubbaren Material auf die Trägerplatte durch gleichzeitiges Sprühen von mindestens einem Oxid und mindestens einem Metall, wobei die äußere Schicht eine erste Phase und eine zweite Phase umfasst, wobei die erste Phase ein Oxid von mindestens einem ersten Metall und einem zweiten Metall umfasst, wobei die zweite Phase ein Metall in seiner Metallphase umfasst, wobei das Metall in seiner Metallphase diskrete Volumina bildet, die in oder zwischen dem Oxid der ersten Phase angeordnet sind, wobei die äußere Schicht zwischen 0,1 und 20 Gew% Metall in seiner Metallphase umfasst.

2. Verfahren nach Anspruch 1, wobei die äußere Schicht zwischen 0,1 und 5 Gew% Metall in seiner Metallphase umfasst, wobei der Rest der äußeren Schicht Oxid ist.

3. Verfahren nach Anspruch 1 oder 2, wobei das Metall der zweiten Phase aus dem ersten Metall des Oxids oder dem zweiten Metall des Oxids besteht.

4. Verfahren nach einem der vorhergehenden Ansprüche, wobei das erste Metall des Oxids und/oder das zweite Metalls des Oxids aus der Gruppe bestehend aus den Elementen der Gruppe lla des periodischen Systems, den Elementen der Gruppe llb des periodischen Systems, den Elementen der Gruppe Illa des periodischen Systems, den Elementen der Gruppe IVa des periodischen Systems, Titanium, Niobium, Tantal, Molybdän und Antimon ausgewählt ist/sind.

5. Verfahren nach einem der vorhergehenden Ansprüche, wobei das erste Metall des Oxids aus der Gruppe bestehend aus Magnesium, Calcium, Titanium, Zink, Cadmium, Gallium, Indium und Zinn ausgewählt ist.

6. Verfahren nach einem der vorhergehenden Ansprüche, wobei das zweite Metall des Oxids aus der Gruppe bestehend aus Magnesium, Calcium, Titanium, Niobium, Tantal, Molybdän, Zink, Cadmium, Bor, Aluminium, Gallium, Indium, Germanium, Zinn und Antimon ausgewählt ist.

7. Verfahren nach einem der vorhergehenden Ansprüche, wobei das Oxid aus der Gruppe bestehend aus Indium-Zinn-Oxiden, Indium-Zink-Oxiden, Cadmium-Zinn-Oxiden, Zink-Zinn-Oxiden, Zinklndium-Oxiden, Zink-Aluminium-Oxiden, Magnesium-Indium-Oxiden und Gallium-Indium-Oxiden ausgewählt ist.

8. Verfahren nach einem der vorhergehenden Ansprüche, wobei das erste Metall der Metallphase aus der Gruppe bestehend aus den Elementen der Gruppe Ila des periodischen Systems, den Elementen der Gruppe Ilb des periodischen Systems, den Elementen der Gruppe llla des periodischen Systems, den Elementen der Gruppe IVa des periodischen Systems, Titanium, Niobium, Tantal, Molybdän und Antimon ausgewählt ist.

9. Verfahren nach einem der vorhergehenden Ansprüche, wobei die Trägerplatte eine ebene oder eine röhrenförmige Trägerplatte umfasst.

10. Verfahren nach einem der vorhergehenden Ansprüche, wobei das Verfahren weiter den Schritt des Aufbringens einer Bindungsschicht auf die Trägerplatte vor dem Aufbringen der äußeren Schicht eines zerstäubbaren Materials umfasst.

11. Oxid-Sputtertarget, umfassend eine Trägerplatte und eine äußere Schicht aus einem zerstäubbaren Material, wobei die äußere Schicht aus einem zerstäubbaren Material durch gleichzeitiges Sprühen von mindestens einem Oxid und mindestens einem Metall erhalten werden kann, wobei die äußere Schicht eine erste Phase und eine zweite Phase umfasst, wobei die erste Phase ein Oxid von mindestens einem ersten Metall und einem zweiten Metall umfasst, wobei die zweite Phase ein Metall in seiner Metallphase umfasst, wobei das Metall in seiner Metallphase diskrete Volumina bildet, die in oder zwischen dem Oxid der ersten Phase angeordnet sind, wobei die äußere Schicht zwischen 0,1 und 20 Gew% Metall in seiner Metallphase umfasst.

12. Oxid-Sputtertarget nach Anspruch 11, wobei die äußere Schicht zwischen 0,1 und 5 Gew% Metall in seiner Metallphase umfasst, wobei der Rest der äußeren Schicht Oxid ist.

13. Oxid-Sputtertarget nach Anspruch 11 oder 12, wobei das Metall der zweiten Phase aus dem ersten Metall des Oxids oder dem zweiten Metall des Oxids besteht.

14. Oxid-Sputtertarget nach einem der Ansprüche 11 bis 13, Verfahren nach einem der vorhergehenden Ansprüche, wobei das erste Metall des Oxids und/oder das zweite Metalls des Oxids aus der Gruppe bestehend aus den Elementen der Gruppe IIa des periodischen Systems, den Elementen der Gruppe Ilb des periodischen Systems, den Elementen der Gruppe Illa des periodischen Systems, den Elementen der Gruppe lVa des periodischen Systems, Titanium, Niobium, Tantal, Molybdän und Antimon ausgewählt ist/sind.

15. Oxid-Sputtertarget nach einem der Ansprüche 11 bis 14, wobei die Trägerplatte eine ebene oder eine röhrenförmige Trägerplatte umfasst.

## Revendications

1. Procédé de fabrication d'une cible de pulvérisation cathodique d'oxyde, ledit procédé comprenant les étapes consistant à :
- fournir un porte-cible ;
- appliquer une couche extérieure d'un matériau pulvérisable de façon cathodique sur ledit porte-cible en pulvérisant simultanément au moins un oxyde et au moins un métal, ladite couche extérieure comprenant une première phase et une seconde phase, ladite première phase comprenant un oxyde d'au moins un premier métal et d'un second métal, ladite seconde phase comprenant un métal dans sa phase métallique, dans lequel ledit métal dans sa phase métallique forme des volumes distincts agencés dans ou entre ledit oxyde de ladite première phase, ladite couche extérieure comprenant entre 0,1 et 20% en poids de métal dans sa phase métallique.

2. Procédé selon la revendication 1, dans lequel ladite couche extérieure comprend entre 0,1 et 5% en poids de métal dans sa phase métallique, le reste de ladite couche extérieure étant de l'oxyde.

3. Procédé selon la revendication 1 ou 2, dans lequel ledit métal de ladite seconde phase est constitué dudit premier métal dudit oxyde ou dudit second métal dudit oxyde.

4. Procédé selon une quelconque des revendications précédentes, dans lequel ledit premier métal dudit oxyde et/ou ledit second métal dudit oxyde est/sont sélectionnés parmi le groupe constitué des éléments du groupe Ila du système périodique, des éléments du groupe Ilb du système périodique, des éléments du groupe Illa du système périodique, des éléments du groupe IVa du système périodique, de titane, de niobium, de tantale, de molybdène et d'antimoine.

5. Procédé selon une quelconque des revendications précédentes, dans lequel ledit premier métal dudit oxyde est sélectionné parmi le groupe constitué de magnésium, de calcium, de titane, de zinc, de cadmium, de gallium, d'indium et d'étain.

6. Procédé selon une quelconque des revendications précédentes, dans lequel ledit second métal dudit oxyde est sélectionné parmi le groupe constitué de magnésium, de calcium, de titane, de niobium, de tantale, de molybdène, de zinc, de cadmium, de bore, d'aluminium, de gallium, d'indium, de germanium, d'étain et d'antimoine.

7. Procédé selon une quelconque des revendications précédentes, dans lequel ledit oxyde est sélectionné parmi le groupe constitué d'oxydes d'indium-étain, d'oxydes d'indium-zinc, d'oxyde de cadmium-étain, d'oxydes de zinc-étain, d'oxydes de zinc-indium, d'oxydes de zinc-aluminium, d'oxydes de magnésium-indium et d'oxydes de gallium-indium.

8. Procédé selon une quelconque des revendications précédentes, dans lequel ledit métal de ladite phase métallique est sélectionné parmi le groupe constitué des éléments du groupe Ila du système périodique, des éléments du groupe Ilb du système périodique, des éléments du groupe Illa du système périodique, des éléments du groupe IVa du système périodique, de titane, de niobium, de tantale, de molybdène et d'antimoine.

9. Procédé selon une quelconque des revendications précédentes, dans lequel ledit porte-cible comprend un porte-cible plan ou tubulaire.

10. Procédé selon une quelconque des revendications précédentes, dans lequel ledit procédé comprend en outre l'étape consistant à appliquer une couche de liaison sur ledit porte-cible avant l'application de ladite couche extérieure d'un matériau pulvérisable de façon cathodique.

11. Cible de pulvérisation cathodique d'oxyde comprenant un porte-cible et une couche extérieure d'un matériau pulvérisable de façon cathodique, ladite couche extérieure d'un matériau pulvérisable de façon cathodique pouvant être obtenue en pulvérisant simultanément au moins un oxyde et au moins un métal, ladite couche extérieure comprenant une première phase et une seconde phase, ladite première phase comprenant un oxyde d'au moins un premier métal et un second métal, ladite seconde phase comprenant un métal dans sa phase métallique, dans laquelle ledit métal dans sa phase métallique forme des volumes distincts agencés dans ou entre ledit oxyde de ladite première phase, ladite couche extérieure comprenant entre 0,1 et 20% en poids de métal dans sa phase métallique.

12. Cible de pulvérisation cathodique d'oxyde selon la revendication 11, dans laquelle ladite couche extérieure comprend entre 0,1 et 5% en poids de métal dans sa phase métallique, le reste de ladite couche extérieure étant de l'oxyde.

13. Cible de pulvérisation cathodique d'oxyde selon la revendication 11 ou 12, dans laquelle ledit métal de ladite seconde phase est constitué dudit premier métal dudit oxyde ou dudit second métal dudit oxyde.

14. Cible de pulvérisation cathodique d'oxyde selon une quelconque des revendications 11 à 13, dans laquelle ledit premier métal dudit oxyde et/ou ledit second métal dudit oxyde est/sont sélectionnés parmi le groupe constitué des éléments du groupe IIa du système périodique, des éléments du groupe IIb du système périodique, des éléments du groupe IIIa du système périodique, des éléments du groupe IVa du système périodique, de titane, de niobium, de tantale, de molybdène et d'antimoine.

15. Cible de pulvérisation cathodique d'oxyde selon une quelconque des revendications 11 à 14, dans laquelle ledit porte-cible comprend un porte-cible plan ou tubulaire.
